Europäisches Patentamt

European Patent Office

Office européen des brevets

(11) Publication number: **0 171 831**
**B1**

# EUROPEAN PATENT SPECIFICATION

(45) Date of publication of patent specification: **01.03.89**

(51) Int. Cl.⁴: **G 01 N 24/06, H 01 F 7/02**

(21) Application number: **85201068.5**

(22) Date of filing: **03.07.85**

(54) **Nuclear magnetic resonance apparatus with a magnet of permanent magnetic material.**

(30) Priority: **17.07.84 NL 8402249**

(43) Date of publication of application:
**19.02.86 Bulletin 86/08**

(45) Publication of the grant of the patent:
**01.03.89 Bulletin 89/09**

(84) Designated Contracting States:
**CH DE FR GB LI NL**

(56) References cited:
**EP-A-0 111 218**
**WO-A-84/00611**
**WO-A-84/01226**
**US-A-4 355 236**

(73) Proprietor: **N.V. Philips' Gloeilampenfabrieken**
**Groenewoudseweg 1**
**NL-5621 BA Eindhoven (NL)**

(72) Inventor: **Zijlstra, Hinne**
**c/o INT. OCTROOIBUREAU B.V. Prof. Holstlaan 6**
**NL-5656 AA Eindhoven (NL)**

(74) Representative: **Scheele, Edial François et al**
**INTERNATIONAAL OCTROOIBUREAU B.V. Prof.**
**Holstlaan 6**
**NL-5656 AA Eindhoven (NL)**

Courier Press, Leamington Spa, England.

## Description

The invention relates to a nuclear magnetic resonance apparatus with a system of magnets built up from permanent magnetic material for generating a homogeneous main magnetic field. A homogeneous magnetic field is to be understood herein to mean a magnetic field whose magnitude has a uniform spatial distribution throughout a given region, e.g. an examination region.

An apparatus of this type is known from the PCT patent application WO 84/01226.

A drawback of the apparatus described therein is that the direction of magnetisation of each of the blocks employed must be accurately directed since the position of each block in the magnet system, apart from a facility for axial adjustment, is completely determined by the geometry of the blocks and of the magnetic system. Only a slight change in the direction of magnetisation of the individual blocks can cause a disturbing amount of non-uniformity in the main field.

The invention aims at overcoming this drawback, to which end a nuclear magnetic resonance apparatus of the kind mentioned in the preamble has the novel feature that the permanent magnetic material has the form of bars mounted in the magnet system and which are capable of post-adjustment as regards the direction of magnetisation.

Proceeding from a substantially circular cylindrical measurement space the permanent magnetic material will surround a circular cylindrical space whose diameter and whose length, adjusted thereto, can still be freely chosen. In matched cylindrical coordinates whose z direction coincides with an axis of the cylindrical measurement space it can then be calculated, with r and φ as further coordinates, that the radial field strength in an x direction is maximum if, for the magnetisation of the surrounding permanent magnetic material with the x axis, satisfies the relationship $\alpha = 2\varphi$ for all directions, where $\alpha$ is the angle between the x axis and the magnetisation direction. It also appears in this case that no field strength prevails in the y direction, perpendicular to the x direction. The strength of the field in the x direction in this case will be inversely proportional to $\mu$, the magnetic permeability of the permanent magnetic material and inversely proportional to the square of the radius r of the enclosed cylindrical space.

In a preferred embodiment the permanent magnetic material consists of a number of diametrically magnetised cylindrical bars which surround a cylindrical measurement space and are mounted in such a way that each of the bars is rotatable about an axis at right angles to the direction of magnetisation of the bars. In particular the bars are circular-cylindrical and the magnet system comprises for example 12 to 24 of such bars. An advantage of using circular-cylindrical shaped bars is that the magnetisation can be mutually identical for all the bars, so that only one kind of magnetised bar will need to be used in the entire magnet system.

In another preferred embodiment the bars have a cross-section substantially in the form of a sector of a cylindrical shell, for example corresponding to the radial cross-section of the blocks as indicated in PCT 84/01226, but are mounted in such a. way that sufficient space is available to allow for a certain amount of rotation of each of the bars about a longitudinal axis thereof.

In a further embodiment the magnet system comprises more than one, for example two, concentric cylindrical distributions of bars whereby for example bars situated more inwardly as seen from the z direction show a central interruption and those situated more outwardly cover this interruption and terminate at opposite ends either at the same or at different longitudinal positions to the ends of the bars situated more inwardly.

In a further embodiment the bars are mounted in such a way that the direction of magnetisation of the whole system is uniform in direction, for example parallel to the x direction for all the bars. A jacket of material with a high magnetic permeability must then be fitted as a return yoke around the permanent magnetic system.

In a further embodiment the geometry of the bars, possibly with extra shim material or shim coils, provides a high degree of field homogeneity if desired, especially near an open end region of the magnet system.

In the following some preferred embodiments in accordance with the invention will be described in more detail with reference to the drawings, in which:

Figure 1 shows a nuclear magnetic resonance apparatus equipped with a permanent magnet,

Figure 2 shows a schematic cross-section of a circular-cylindrical magnet with circular-cylindrical bars magnetised according to the relationship = 2φ,

Figure 3 shows a permanent magnet composed of bars in the form of sectors of a cylindrical shell,

Figure 4 shows a similar system with two cylindrical distribution of bars mounted coaxially.

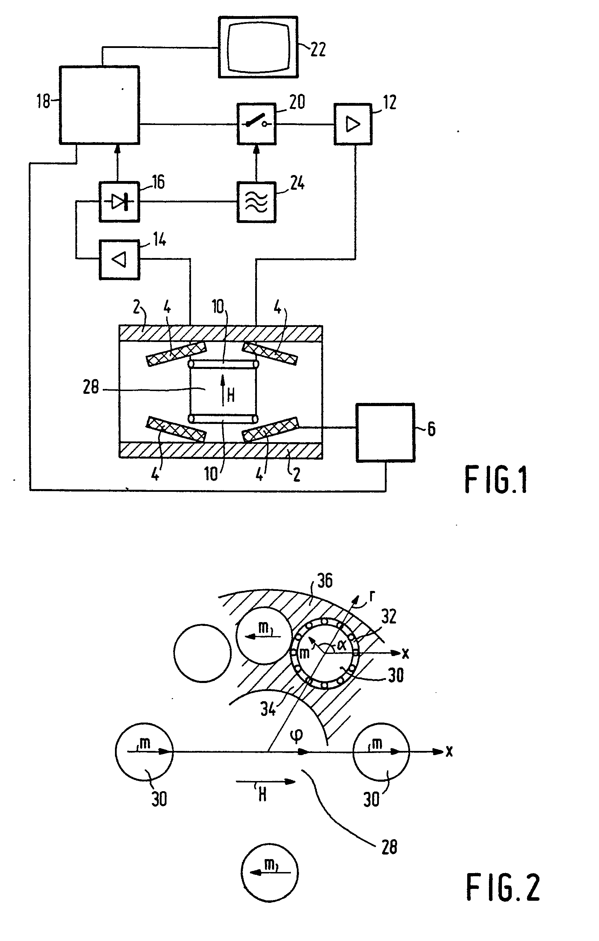

A nuclear magnetic resonance apparatus as shown in figure 1 contains a permanent magnet system 2 for generating a steady homogeneous magnetic field H, a magnet system 4 for generating gradient magnetic fields, and a power source 6 for the gradient coils 4. A magnet coil 10 serves for generating a radio-frequency alternating magnetic excitation field for which purpose it is connected to a radio-frequency source 12. For detection of nuclear magnetic resonance signals generated by the radio-frequency excitation field in an object under examination, use is also made in the apparatus of Figure 1, for simplicity, of the radio-frequency coil 10 which is connected to a signal amplifier 14 for that purpose. The signal amplifier 14 is connected to a phase-sensitive rectifier 16 which is connected to a central control unit 18. The control unit 18 further controls a modulator 20 for the radio-frequency source 12, the power source 6 for the gradient coils and a monitor 22 for image display. A high-frequency oscillator 24 feeds both the modulator 20 and the phase-sensitive rectifier 16 which processes the measurement signals. The excitation coil 10 placed within the magnet systems 2 and 4 encloses and defines a measurement space 28 which, in an apparatus for medical diagnostic measurements, is large enough to accommodate a patient. Thus there must be generated in the measurement space 28 a homogeneous magnetic field H, gradient fields required for selecting the position of a cross-section to be measured and displayed, and a spatially uniform radio-frequency alternating field. For certain examinations such as those carried out on more peripheral parts of the body, but also for the spinal cord, it may be advantageous to use coils for detection whose shape can be adapted at least in part to that part of the body under examination, such as surface coils for localised examinations of the body such as the heart or the spinal cord, or solenoid-type coils for more peripheral parts of the body that can be comprised therein. In the latter connection mammary investigations are a particular case in point. These detection coils are then incorporated in the measurement space, where the excitation coil can generate a locally homogeneous radio-frequency field. When a solenoid-type coil is used it can again combine the function of an excitation coil and a measurement coil.

An embodiment of a permanent magnet assembly in accordance with the invention, shown in radial cross-section in figure 2, contains in a circular-cylindrical distribution geometry an arrangement of circular-cylindrical bars 30 which surround the measurement space 28 and which are magnetised in a direction $m$ indicated by arrows. The bars consist of permanent magnetic materials such as ferrite, $SmCo_5$, $Sm(Fe\ Co\ Cu\ Zr)_{7.5}$, $Nd_{12}Fe_{14}B$ or $Sm(Co\ Cu)_5$. The measurement space has for so-called total body measurements an inside diameter of for example approximately 1 m and a length of 1.5 to 2 m. The required quantity of magnetic material and hence the diameter of the bars is dependent on the permanent magnetic material chosen, the number of bars and the required magnetic field strength in the measurement space. An optimally uniform magnetic field H will be provided in the measurement space if the direction of magnetisation $m$ of the permanent magnetic material always satisfies the condition $= 2\varphi$, where $\varphi$ is the polar coordinate angle between the x axis and the radius r towards a relevant bar 30 and $\alpha$ is the angle between the x axis and the direction of magnetisation m. As indicated in the figure for successive positions around the axis, the direction x of the magnetisation thus changes at an angular rate which is twice the rate of change of the angular direction of the radius. Inside the cylinder a magnetic field H is thus generated which, when shim material is used, is sufficiently uniform in a relatively large part of the enclosed space. The permanent magnetic material preferably shows in addition to a high intensity of magnetisation in order to achieve a relatively high field H with relatively little material, a low temperature coefficient for the magnetisation in order to keep the field stable in relation to changes in temperature, and good spatial uniformity, a high coercitivity in order to shield the magnetisation against external fields, and a high field anisotropy to avoid local disturbances of the magnetisation.

Each of the bars 30 is incorporated in a holder 32 which in turn is incorporated in an inner carrier 34, which must not affect the magnetic field, and an outer carrier 36 which may for example form part of a shield, in particular a magnetic shield, but which with this geometry of magnetisation is not strictly necessary. The bar 30 can be rotated in the holder 32 and in this way the homogeneity of the magnetic field H can be optimised. If required the holder 32 can also be mounted in the carrier combination 34—36 in such a way that the bar is radially displaceable with the holder 32 and can thus be post-adjusted. Since all bars here are identical, there will not however be much need for this. The bars can be magnetised in the form in which they are to be used, but it is also possible to take for example magnetised rectangular bars and then subsequently give them the required shape. To make this operation simpler, the cross-section of the bars can have the shape of a regular polygon. Each of the bars can then be similarly incorporated in a holder such as the holder 32 of which the inside diameter is such that the inner surface then forms an enclosing supporting surface for the bar. The number of bars depends on the degree of homogeneity aimed at and can be for example any number from 12 to 24.

In complete correspondence it is alternatively possible to use a uniformly magnetised system that is to say one in which the direction of the magnetisation is mutually parallel for all the bars, for example parallel to the x axis in figure 2. A disadvantage of such a system is that from the magnetic viewpoint it does not form a closed system but exhibits a partly external return field which balances the required internal field and could give rise to a stray external field. As already remarked, this can be overcome by means of a soft magnetic shield which is thus necessary in this case. In themselves the bars can be identical to those of the system described earlier. Bars magnetised in accordance with the invention can be used in both systems. Apart from the shield, it is thus possible to convert one system into the other simply by rotating the bars. The post-alignment of the bars can be performed entirely empirically, but it is also possible from the measured effect of the magnetisation direction of each of the bars on the homogeneity of the field, to compose an algorithm for the alignment of each of the bars. From consideration of symmetry this will preferably be done in pairs, i.e. with pairs of bars mounted diametrically with respect to the system. The effect of each of the bars or of each of the pairs of bars can be calculated, but it can also be determined empirically, given a known rotation, by measuring the effect on the field in the measurement space.

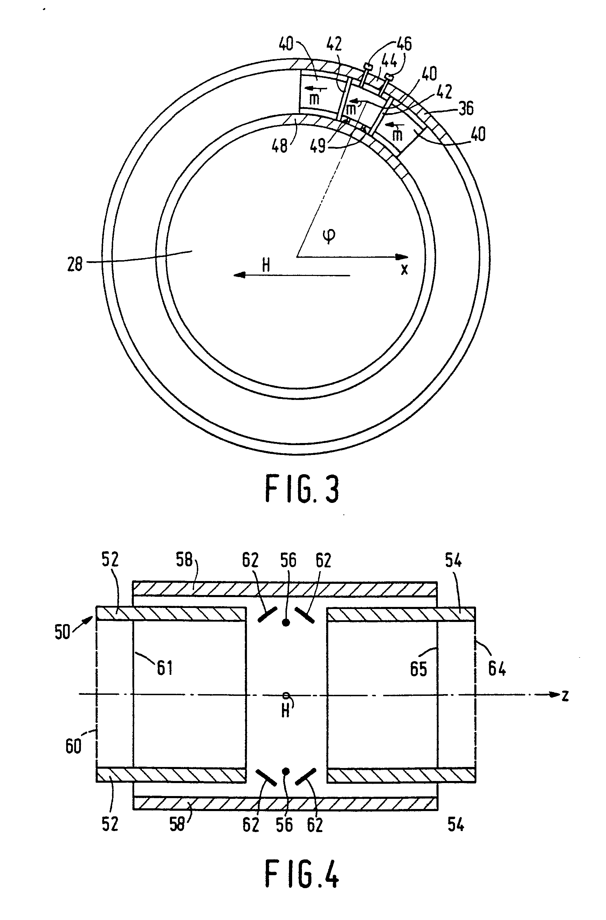

A more compact structure of permanent magnetic material is obtained when, as indicated in figure 3, the lateral cross-section of each of the bars is given the shape of a sector of a cylindrical shell matched to the required geometry. Bars 40 with such a cross-section are again composed to form a magnet system with a measurement space 28. Spaces 42 between the bars allow for a rotation here too, although to a limited extent. The space 42 does not have to be large to enable the uniformity of the field to be set optimally since the direction of magnetisation of each of the bars can be reasonably accurately defined during fabrication. The setting can be realised here for example by mounting the bars in a carrier 44 which is provided with adjusting screws 46 and possibly with a carrier 48 which is fitted with sprung elements 49, for example of sufficiently resilient material. The practical advantage that all bars are mutually identical and interchangeable is not applicable in this case. Since, owing to the post-alignment of the direction of magnetisation, the magnetic field can be given a higher order of uniformity, it will be advantageous to employ more than the eight elements mentioned in WO 84/01226. Here too, depending on the geometry and the desired degree of uniformity, a number ranging from 12 to 24 bars is to be recommended. In a completely analogous way, one can work here too with a system magnetised according to the relationship $\alpha = 2\varphi$ or with a system employing uniform magnetisation. Here of course the systems are not mutually convertible and a return yoke is again required for the latter configuration.

Up to now a single cylindrical distribution has been considered. An embodiment as sketched in longitudinal section in figure 4 shows two coaxial cylindrical distributions of bars. A first or inner distribution 50 consists of two parts 52 and 54 with a spacing 56 and a second or outer distribution 58 which here consists of bars without a spacing. Each of the systems 52, 54 and 58 is built up in the same way as the systems earlier described. With such a system a magnet can be composed whose field H is also sufficiently uniform for diagnostic measurements near, for example, an end face 60 of the magnet. The geometry, in particular the relative position of the end face 60 of the inner distribution and of an end plane 61 of the outer distribution and the size of the interruption 56 can be optimised in order to render the magnetic field uniform near the end plane 60. For this purpose extra magnetic material or a cooperating electromagnet coil can be added. A magnet which provides a magnetic field with a high degree of uniformity near an end face is particularly suitable for breast examinations, for example. The diameter of the magnet and hence the overall dimensions and total weight thereof can be significantly reduced with a magnet specifically designed for this purpose. A diameter of 15 to 20 cm is then sufficient. If a common solenoid is then used both as the excitation and as the measurement coil, the result will be a cheap, easily operated nuclear magnetic resonance apparatus which will require no energy for the main field. The diameter of the magnet can be further reduced by using an arrangement in which a gradient coil system 62 is incorporated in the space 56. From symmetry considerations such a magnet is in principle capable of simultaneous individual use at both ends. Since, given a proper construction, the field at an end face 64 is identical with the field at the end face 60, one of the ends of the magnet can also be used as a reference, for example with a dummy object, enabling corrections to be made for symmetric field inhomogeneities. If the mutual disposition of the end faces of the two distributions is made different at each end of the magnet, the magnet can be made asymmetric. The magnetic field near each of the ends can then be matched to a different specific application.

**Claims**

1. Nuclear magnetic resonance apparatus with a magnet system of magnets (2) built up from permanent magnetic material for generating a homogeneous main magnetic field (H), in which the permanent magnetic material is in the form of bars (30, 40), which are with respect to the direction of magnetisation, adjustably mounted in the magnet system.

2. Nuclear magnetic resonance apparatus as claimed in claim 1, in which the magnet system is substantially circular-cylindrical in shape and each bar (30) is disposed in such a manner that the angle ($\alpha$) between the direction of magnetisation (m) of the permanent magnetic material and a fixed x-direction is always twice the polar angle ($\varphi$) subtended between the radius (r) joining the axis of the magnet system and the centre of the relevant volume occupied by said bar (30).

3. Nuclear magnetic resonance apparatus as claimed in claim 1, in which the permanent magnetic material in the magnet system has a uniform direction of magnetisation.

4. Nuclear magnetic resonance apparatus as claimed in one of the foregoing claims, in which the magnet system is substantially circular-cylindrical and each of the bars (30, 40) is cross-magnetised and is rotatable about an axis at right angles to the direction of magnetisation.

5. Nuclear magnetic resonance apparatus as claimed in any one of the foregoing claims, in which the bars (30) each have a circular cross-section.

6. Nuclear magnetic resonance apparatus as claimed in claim 4, in which the magnet system contains two coaxial cylindrical distributions of permanent magnetic bars (50, 58).

7. Nuclear magnetic resonance apparatus as claimed in claim 6, in which at least one of the cylindrical distribution of bars shows an interruption (56) in the axial direction.

8. Nuclear magnetic resonance apparatus as claimed in any one of the foregoing claims, in which magnetic correction means are provided for increasing the degree of uniformity of the magnetic field at least at an axial end (60, 64) of the magnet system.

9. Nuclear magnetic resonance apparatus as claimed in claim 7, in which the magnet system provides an effective measurement space with a diameter of about 20 cm near at least one of the ends thereof.

## Patentansprüche

1. Kernspinresonanzanordnung mit einem Magnetsystem (2) aus dauermagnetischem Material zum Erzeugen eines homogenen Hauptmagnetfelds (H), in dem das dauermagnetische Material die Form von Balken (30, 40) hat, die hinsichtlich des Magnetisierungsrichtung im Magnetsystem einstellbar angeordnet sind.

2. Kernspinresonanzanordnung nach Anspruch 1, dadurch gekennzeichnet, dass das Magnetsystem im wesentlichen eine kreiszylindrische Form hat, und dass jeder Balken (30) derart angeordnet ist, dass der Winkel (α) zwischen der Magnetisierungsrichtung (m) des dauermagnetischen Materials und einer festen x-Richtung immer das Zweifache des Polwinkels (φ) ist, der zwischen dem Radius (r) eingeschlossen ist, der die Achse des Magnetsystems und die Mitte des von diesem Balken (30) eingenommenen relevanten Volumens zusammenbringt.

3. Kernspinresonanzanordnung nach Anspruch 1, dadurch gekennzeichnet, dass das dauermagnetische Material im Magnetsystem eine einheitliche Magnetisierungsrichtung besitzt.

4. Kernspinresonanzanordnung nach einem oder mehreren der vorangehenden Ansprüche, dadurch gekennzeichnet, dass das Magnetsystem im wesentlichen kreiszylindrisch ist und jeder der Balken (30, 40) kreuzweise magnetisiert und um eine Achse senkrecht zur Magnetisierungsrichtung drehbar ist.

5. Kernspinresonanzanordnung nach einem oder mehreren der vorangehenden Ansprüche, dadurch gekennzeichnet, dass jeder Balken (30) einen kreisförmigen Querschnitt hat.

6. Kernspinresonanzanordnung nach Anspruch 4, dadurch gekennzeichnet, dass das Magnetsystem zwei koaxiale zylindrische Verteilungen dauermagnetischer Balken (50, 58) enthält.

7. Kernspinresonanzanordnung nach Anspruch 6, dadurch gekennzeichnet, dass wenigstens eine der zylindrischen Verteilingen von Balken eine Unterbrechung (56) in der axialen Richtung aufweist.

8. Kernspinresonanzanordnung nach einem oder mehreren der vorangehenden Ansprüche, dadurch gekennzeichnet, dass magnetische Korrekturmittel zum Erhöhen des Einheitsgrades des Magnetfelds wenigstens an einem axialen Ende (60, 24) des Magnetsystems vorgesehen sind.

9. Kernspinresonanzanordnung nach Anspruch 7, dadurch gekennzeichnet, dass das Magnetsystem einen wirksamen Messraum mit einem Durchmesser von etwa 20 cm nahe bei wenistens einem seiner Enden bildet.

## Revendications

1. Appareil de résonance magnétique nucléaire comportant un système magnétique d'aimants (2) fait d'un matériau à magnétisme permanent pour engendrer un champ magnétique principal homogène (H), dans lequel le matériau à magnétisme permanent a la forme de barreaux (30, 40) qui sont montés de façon réglable par rapport à la direction de magnétisation dans le système magnétique.

2. Appareil de résonance magnétique nucléaire suivant la revendication 1, dans lequel le système magnétique est en substance de forme cylindro-circulaire et chaque barreau (30) est disposé d'une manière telle que l'angle (α) entre la direction de magnétisation (m) du matériau à magnétisme permanent et une direction x fixe soit toujours égal au double de l'angle polaire (φ) sous-tendu entre le rayon (r) reliant les axes du système magnétique et le centre du volume en question occupé par le barreau (30).

3. Appareil de résonance magnétique nucléaire suivant la revendication 1, dans lequel le matériau à magnétisme permanent dans le système magnétique a une direction de magnétisation uniforme.

4. Appareil de résonance magnétique nucléaire suivant l'une quelconque des revendications précédentes, dans lequel le système magnétique est en substance cylindro-circulaire et chacun des barreaux (30, 40) est magnétisé transversalement et peut tourner autour d'un axe perpendiculaire à la direction de magnétisation.

5. Appareil de résonance magnétique nucléaire suivant l'une quelconque des revendications précédentes, dans lequel les barreaux (30) ont chacun une section transversale circulaire.

6. Appareil de résonance magnétique nucléaire suivant la revendication 4, dans lequel le système magnétique contient deux distributions cylindriques coaxiales de barreaux à magnétisme permanent (50, 58).

7. Appareil de résonance magnétique nucléaire suivant la revendication 6, dans lequel au moins une des distributions cylindriques de barreaux présente une interruption (56) dans le sens axial.

8. Appareil de résonance magnétique nucléaire suivant l'une quelconque des revendications précédentes, dans lequel des moyens de correction magnétique sont prévus pour augmenter le degré d'uniformité du champ magnétique au moins à une extrémité axiale (60, 64) du système magnétique.

9. Appareil de résonance magnétique nucléaire suivant la revendication 7, dans lequel le système magnétique procure un espace de mesure efficace présentant un diamètre d'environ 20 cm près d'au moins une de ses extrémités.

FIG.1

FIG.2

FIG. 3

FIG. 4